**Europäisches Patentamt**

**European Patent Office**

**Office européen des brevets**

(11) Veröffentlichungsnummer : **0 351 601 B1**

(12) **EUROPÄISCHE PATENTSCHRIFT**

(45) Veröffentlichungstag der Patentschrift :
**09.12.92 Patentblatt 92/50**

(51) Int. Cl.⁵ : **G01R 19/00, H03D 1/12**

(21) Anmeldenummer : **89111809.3**

(22) Anmeldetag : **29.06.89**

(54) **Schaltung zur Detektierung von hochfrequenten Signalen kleiner Amplitude.**

(30) Priorität : **19.07.88 CH 2750/88**

(43) Veröffentlichungstag der Anmeldung :
**24.01.90 Patentblatt 90/04**

(45) Bekanntmachung des Hinweises auf die
Patenterteilung :
**09.12.92 Patentblatt 92/50**

(84) Benannte Vertragsstaaten :
**CH DE GB IT LI NL SE**

(56) Entgegenhaltungen :
**DE-B- 1 072 742**
**US-A- 2 686 870**
**WIRELESS WORLD, Band 82, Nr. 1490, Okto-**
**ber 1976, Seiten 59-60; R. ASHMORE:**
**"Reception and demodulation"**

(73) Patentinhaber : **SIEMENS-ALBIS**
**AKTIENGESELLSCHAFT**
**PV/Patente und Verträge Postfach**
**CH-8047 Zürich (CH)**

(72) Erfinder : **Fognini, Bruno**
**Am Suteracher 3**
**CH-8048 Zürich (CH)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Schaltung zur Detektierung von hochfrequenten Signalen kleiner Amplitude, mit einem Eingangsübertrager, an dessen Sekundärwicklung die wechselstromseitigen Anschlüsse einer Brückengleichrichterschaltung angeschlossen sind, bei der der eine Gleichspannungsausgang über einen Ladekondensator mit dem auf Bezugspotential liegenden anderen Gleichspannungsausgang der Brückengleichrichterschaltung verbunden ist. Eine solche Schaltung wird beispielsweise in Systemen zur Erzeugung bzw. Verarbeitung von hochfrequenten Signalen zur Pegelüberwachung eingesetzt. Sie soll einen geringen schaltungstechnischen Aufwand haben und einen geringen Leistungsbedarf aufweisen.

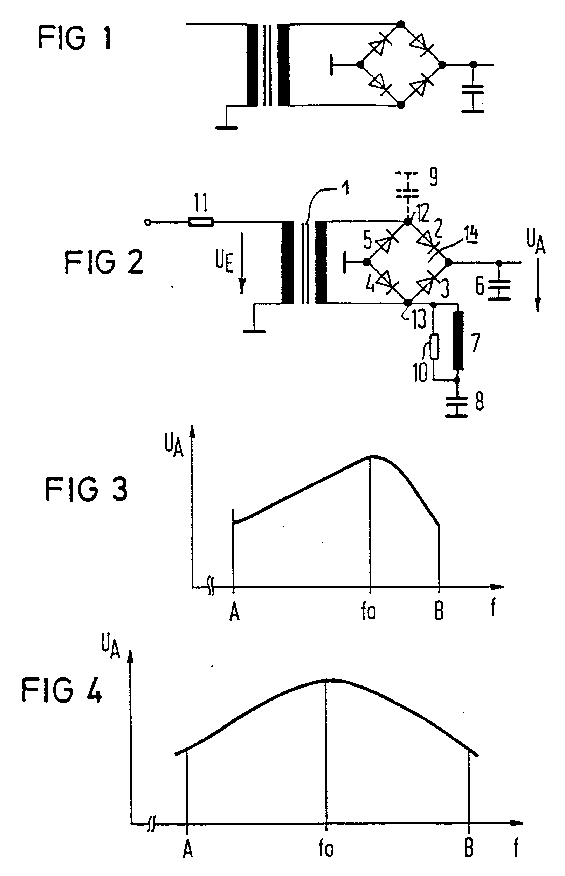

Ein bekannter, schaltungstechnisch einfacher Detektor dieser Art ist in Fig. 1 dargestellt. Über einen Übertrager wird das hochfrequente Signal einer Brückengleichrichterschaltung mit ausgangsseitigem Ladekondensator zugeführt, an dem das gleichgerichtete Signal zur Pegelüberwachung verfügbar ist. Da bei dieser bekannten Anordnung an der Sekundärwicklung des Übertragers mindestens die doppelte Diodendurchlaßspannung bereitgestellt werden muß, bis am Ausgang ein Signal auftritt, weist diese bekannte Schaltungsanordnung eine geringe Empfindlichkeit auf und erfordert deshalb relativ hochpegelige Eingangssignale. Hochfrequente Signale, deren Amplitude an der Sekundärseite des Übertragers unter einem bestimmten Amplitudenpegel - der der doppelten Diodendurchlaßspannung entspricht - liegen, können mit der bekannten Schaltung nicht erfaßt werden.

Erfindungsgemäß ist dies dadurch erreichbar, daß ein Pol der wechselstromseitigen Anschlüsse über eine, gegenüber dem Bezugssignal gleichstrommäßig isolierte Induktivität mit dem Bezugspotential verbunden ist, und daß die Größe der Induktivität so gewählt ist, daß sie mit den Diodenkapazitäten der Brückengleichrichterschaltung für die Betriebsfrequenz einen Parallelresonanzkreis bildet.

Dadurch, daß die Sperrschichtkapazitäten der Brückengleichrichterschaltung durch eine Induktivität zu einem Parallelresonanzkreis ergänzt werden, wird das der Brückenschaltung zugeführte Signal durch Resonanzüberhöhung in der Amplitude angehoben.

Die Unteransprüche zeigen vorteilhafte Ausgestaltungen der Erfindung auf.

Anhand der Zeichnungen wird ein Ausführungsbeispiel näher erläutert. Es zeigen

Fig. 2 die erfindungsgemäß gestaltete Schaltung
Fig. 3 und Fig. 4 ausgewählte frequenzabhängige Signalverläufe hierzu.

Bei der Schaltung nach Fig. 2 ist die Sekundärwicklung eines Übertragers 1 mit den wechselstromseitigen Polen 12 und 13 einer aus vier Dioden 2,3,4,5 bestehenden Brückengleichrichterschaltung 14 verbunden. Ein Gleichspannungsausgang der Brückengleichrichterschaltung 14 ist über einen Ladekondensator 6 mit dem anderen Gleichspannungsausgang verbunden, der auf Bezugspotential liegt. Vom wechselstromseitigen Pol 13 der Brückengleichrichterschaltung 14 ist eine Induktivität 7 mit nachgeschaltetem Koppelkondensator 8 an das Bezugspotential geschaltet. Der Koppelkondensator 8 isoliert dabei den wechselstromseitigen Pol 13 gleichstrommäßig vom Bezugspotential. Über einen Vorwiderstand 11 wird das zu detektierende hochfrequente Signal $U_E$ an die Primärwicklung des Übertragers 1 gelegt und an die wechselstromseitigen Anschlüsse 12,13 der Brückengleichrichterschaltung 14 übertragen.

Die Größe der Induktivität 7 ist dabei so gewählt, daß sie mit den Diodenkapazitäten der Brückengleichrichterschaltung 14 einen Parallelresonanzkreis bildet, dessen Resonanzfrequenz $f_0$ im Idealfall der Frequenz f (Betriebsfrequenz) des zu erfassenden Eingangssignales $U_E$ entspricht. Es ist auch denkbar, daß die vier Dioden 2,3,4,5 der Brückengleichrichterschaltung 14 als Kapazitätsdioden ausgeführt sind, die eine höhere Sperrschichtkapazität aufweisen als normale Halbleiterdioden. Die bei der Resonanzfrequenz $f_0$ des Parallelresonanzkreises erhaltene Spannungsresonanzüberhöhung wird durch die Brückengleichrichterschaltung 14 gleichgerichtet, wobei am Ladekondensator 6 eine der Spannungsresonanzüberhöhung proportionale höhere Gleichspannung $U_A$ zur Signalauswertung verfügbar ist. Da die Schaltung frequenzselektiv arbeitet, ist es erforderlich, die Resonanzfrequenz $f_0$ des Parallelresonanzkreises auf die Frequenz des zu detektierenden Signales $U_E$ abzustimmen. Bei der Abstimmung ist des weiteren auf die Höhe des Signalpegels des zu detektierenden Signales $U_E$ zu achten, da die Sperrschichtkapazität einer Diode z. B. 2, insbesondere bei Verwendung von Kapazitätsdioden, mit zunehmender Sperrspannung abnimmt. Dieser Umstand kann jedoch vorteilhaft dadurch ausgenutzt werden, in dem z. B. bei einer Pegelreduktion des Signales $U_E$ die Ausgangsgleichspannung $U_A$ am Ladekondensator 6 überproportional abfällt, was wiederum die Auswertemöglichkeit erleichtern kann. Vorteilhafterweise kann durch die Verwendung einer in ihrer Größe veränderbaren Induktivität die Resonanzfrequenz $f_0$ des Parallelresonanzkreises auf die Frequenz und-/oder den Signalpegel des zu detektierenden Signals $U_E$ abgestimmt werden.

Fig. 3 zeigt den Signalverlauf der Gleichspannung $V_A$ unter dem Einfluß des Parallelresonanzkreises in Abhängigkeit von der Frequenz f in Resonanzfrequenznähe. Es sei beispielsweise angenommen, daß der Parallelresonanzkreis bei einem bestimmten Eingangspegel eine Resonanzfrequenz $f_0$ von 200 MHz aufweist. Die dabei auftretende Spannungsresonanzüberhöhung beginnt im Punkt A, der etwa bei 170 MHz liegt und erreicht ihr Maximum bei der Resonanzfrequenz $f_0$ und endet im Punkt B bei ca. 210 MHz. Ein durch Parallelresonanz zu detektierendes Eingangssignal $U_E$ kann dabei eine Frequenz aufweisen, die innerhalb des durch die Punkte A und B gebildeten Frequenzbereiches liegt, wobei es für eine einwandfreie Signaldetektion um so günstiger ist, je näher sich die Frequenz f bei der Resonanzfrequenz $f_0$ befindet. Die durch die Punkte A und B gebildete Bandbreite des Parallelresonanzkreises kann dadurch beeinflußt werden, daß ein Widerstand 10 parallel zur Induktivität 7 geschaltet ist, wodurch der durch die Punkte A und B festgelegte Frequenzbereich zunimmt. Die Unsymmetrie des Signalverlaufes nach Fig. 3 bezüglich der Resonanzfrequenz $f_0$ kann vorteilhaft dadurch symmetriert werden, daß der andere Pol 12 des wechselstromseitigen Anschlußes der Brückengleichrichterschaltung 14 über einen Zusatzkondensator 9 (in Fig. 2 gestrichelt dargestellt) mit dem Bezugspotential verbunden ist. Durch geeignete Wahl der Kapazität des Zusatzkondensators 9 ist es möglich, den Signalverlauf der Gleichspannung $U_A$ unter dem Einfluß des Parallelresonanzkreises bezüglich seiner Resonanzfrequenz $f_0$ zu symmetrieren, wie in Fig. 4 dargestellt ist. Die Punkte A und B liegen jetzt symmetrisch bezüglich der Resonanzfrequenz $f_0$, wobei die eigentliche Empfindlichkeit des Parallelresonanzkreises nicht beeinträchtigt wird. Die Eingangsimpedanz der Schaltungsanordnung kann mit dem Übersetzungsverhältnis des Übertragers 1 und-/oder den Vorwiderstand 11 in bekannter Weise beeinflußt werden. Dabei kann das Übersetzungsverhältnis des Übertragers nicht beliebig erhöht werden, da mit größer werden dem Übersetzungsverhältnis die Streuinduktivitäten und die Verluste zunehmen. Durch geeignete Wahl des Übersetzungsverhältnisses, sowie des Widerstandswertes des Widerstands 11 kann vorteilhaft eine hochohmig und reelle Eingangsimpedanz realisiert werden.

Vorteilhaft erweist sich die Schaltung zur Überwachung von hochfrequenten Signalen mit kleiner Amplitude im Frequenzbereich von MHz bis GHz. Besonders vorteilhaft ist eine Anwendung auf dem Gebiet der Mikrowellentechnik zu sehen, da die Komponenten Induktivität 7, Koppelkondensator 8 und Zusatzkondensator 9 mit Streifenleitungen realisiert werden können.

**Patentansprüche**

1. Schaltung zur Detektierung von hochfrequenten Signalen kleiner Amplitude, mit einem Eingangsübertrager (1), an dessen Sekundärwicklung die wechselstromseitigen Anschlüsse (12, 13) einer Brückengleichrichterschaltung (14) angeschlossen sind, bei der der eine Gleichspannungsausgang über einen Ladekondensator (6) mit dem auf Bezugspotential liegenden anderen Gleichspannungsausgang der Brückengleichrichterschaltung (14) verbunden ist,
**dadurch gekennzeichnet,** daß ein Pol (13) der wechselstromseitigen Anschlüsse über eine, gegenüber dem Bezugssignal gleichstrommäßig isolierte Induktivität (7) mit dem Bezugspotential verbunden ist, und daß die Größe der Induktivität (7) so gewählt ist, daß sie mit den Diodenkapazitäten der Brückengleichrichterschaltung (14) für die Betriebsfrequenz (f) einen Parallelresonanzkreis bildet.

2. Schaltung nach Anspruch 1,
**dadurch gekennzeichnet,** daß die gleichstrommäßige Isolierung der Induktivität (7) gegenüber dem Bezugspotential durch einen der Induktivität nachgeschalteten Koppelkondensator (8) vorgenommen ist, dessen Kapazität so groß bemessen ist, daß die Wirkung des Parallelresonanzkreises bei Betriebsfrequenz (f) nicht beeinflußt ist.

3. Schaltung nach einem der vorhergehenden Ansprüche,
**dadurch gekennzeichnet,** daß die Resonanzfrequenz $(f_0)$ des Parallelresonanzkreises durch eine in ihrer Größe veränderbare Induktivität einstellbar ist.

4. Schaltung nach einem der vorhergehenden Ansprüche,
**dadurch gekennzeichnet,** daß am anderen Pol (12) der wechselstromseitigen Anschlüsse 2 ein Zusatzkondensator (9) mit dem Bezugspotential verbunden ist, dessen Kapazität so groß bemessen ist, daß eine Symmetrierung bezüglich der frequenzabhängigen Eingangsempfindlichkeit der Schaltung erreichbar ist.

5. Schaltung nach einem der vorhergehenden Ansprüche,
**dadurch gekennzeichnet,** daß zur Beeinflußung der Bandbreite des Parallelresonanzkreises der Induktivität (7) ein Widerstand (10) parallel zur Induktivität (7) geschaltet ist.

6. Schaltung nach einem der vorhergehenden Asprüche,
**dadurch gekennzeichnet,** daß die Betriebsfrequenz (f) der Schaltung im Bereich von MHz und GHz liegt.

7. Schaltung nach Anspruch 6,
**dadurch gekennzeichnet,** daß für Betriebsfrequenzen (f) der Schaltung im Mikrowellenbereich die Schaltungskomponenten Induktivität (7), Koppelkondensator (8) und Zusatzkondensator (9) als Streifenleitung realisiert sind.

**Claims**

1. Circuit for detecting high-frequency signals of small amplitude, having an input transformer (1), to the secondary winding of which the alternating-current-side terminals (12, 13) of a bridge rectifier circuit (14) are connected, in which the one direct-voltage output is connected by way of a charge capacitor (6) to the other direct-voltage output of the bridge rectifier circuit (14) lying at reference potential, characterized in that one pole (13) of the alternating-current-side terminals is connected by way of an inductance (7), isolated in terms of direct current against the reference signal, to the reference potential, and that the size of the inductance (7) is chosen such that it forms a parallel resonance circuit with the diode capacitances of the bridge rectifier circuit (14) for the operational frequency (f).

2. Circuit according to claim 1, characterized in that direct-current isolation of the inductance (7) against the reference potential is undertaken by a coupling capacitor (8) connected in series with the inductance, the capacitance of the capacitor being measured to be so great that the action of the parallel resonance circuit at operational frequency (f) is not influenced.

3. Circuit according to one of the preceding claims, characterized in that the resonance frequency ($f_0$) of the parallel resonance circuit can be adjusted by an inductance variable in its size.

4. Circuit according to one of the preceding claims, characterized in that at the other pole (12) of the alternating-current-side terminals (2) an additional capacitor (9) is connected to the reference potential, the capacitance of which is measured to be so great that balancing can be attained with respect to the frequency-dependent input sensitivity of the circuit.

5. Circuit according to one of the preceding claims, characterized in that a resistance (10) is connected in parallel with the inductance (7) to influence the bandwidth of the parallel resonance circuit of the inductance (7).

6. Circuit according to one of the preceding claims, characterized in that the operational frequency (f) of the circuit lies in the range of MHz and GHz.

7. Circuit according to claim 6, characterized in that for operational frequencies (f) of the circuit in the microwave region the circuit components of inductance (7), coupling capacitor (8) and additional capacitor (9) are realized as strip conductors.

**Revendications**

1. Circuit pour détecter des signaux à haute fréquence de faible amplitude, comportant un transformateur d'entrée (1) à l'enroulement secondaire duquel sont raccordées les bornes (12,13), situées du côté du courant alternatif, d'un circuit redresseur en pont (14), dans lequel une sortie de la tension continue est raccordée par l'intermédiaire d'un condensateur de charge (6) à l'autre sortie de la tension continue, placée au potentiel de référence, du circuit redresseur en pont (14), caractérisé par le fait qu'un pôle (13) des bornes, situées du côté du courant alternatif, est raccordé au potentiel de référence par l'intermédiaire d'une inductance (7) isolée, du point de vue du courant continu, par rapport au signal de référence, et que la valeur de l'inductance (7) est choisie de manière à former, avec les capacités des diodes du circuit redresseur en pont (14), pour la fréquence de référence (f), un circuit résonnant parallèle.

2. Montage suivant la revendication 1, caractérisé par le fait que l'isolation, côté courant continu, de l'inductance (7) par rapport au potentiel de référence est obtenue au moyen d'un condensateur de couplage (8), branché en aval de l'inductance et dont la capacité est dimensionnée à une valeur telle que l'action du circuit résonnant en parallèle ne s'en trouve pas influencée pour la fréquence de service (f).

3. Montage suivant l'une des revendications précédentes, caractérisé par le fait que la fréquence de résonance ($f_0$) du circuit résonnant parallèle est réglable au moyen d'une inductance dont la valeur est modifiable.

4. Circuit suivant l'une des revendications précédentes, caractérisé par le fait qu'à l'autre pôle (12) des bornes (2), situées du côté du courant alternatif, un condensateur supplémentaire (9) est raccordé au potentiel de référence, la capacité de ce condensateur étant dimensionnée de telle sorte que l'on peut obtenir une symétrisation par rapport à la sensibilité d'entrée du circuit, qui dépend de la fréquence.

5. Circuit suivant l'une des revendications précédentes, caractérisé par le fait qu'une résistance (10) est branchée en parallèle avec l'inductance (7), afin de permettre d'influer sur la largeur de bande du circuit résonnant parallèle.

6. Circuit suivant l'une des revendications précédentes, caractérisé par le fait que la fréquence de service (f) du circuit se situe dans la gamme de MHz et GHz.

7. Circuit suivant la revendication 6, caractérisé par le fait que pour des fréquences de service (f) du circuit dans la gamme des micro-ondes, les composants du circuit comprenant l'inductance (7), le condensateur de couplage (8) et le condensateur supplémentaire (9), sont réalisés sous la forme d'un conducteur en forme de bande.

FIG 1

FIG 2

$U_E$

$U_A$

FIG 3

$U_A$

A    fo    B    f

FIG 4

$U_A$

A    fo    B    f